(19) Europäisches Patentamt / European Patent Office / Office européen des brevets

(11) **EP 4 657 157 A1**

(12) **EUROPEAN PATENT APPLICATION**

(43) Date of publication:
03.12.2025 Bulletin 2025/49

(21) Application number: 25171522.3

(22) Date of filing: 21.04.2025

(51) International Patent Classification (IPC):
G03F 1/62 *(2012.01)*    G03F 7/20 *(2006.01)*
C08G 61/02 *(2006.01)*   C01B 32/15 *(2017.01)*
C08L 65/04 *(2006.01)*

(52) Cooperative Patent Classification (CPC):
G03F 7/70983; C01B 32/15; C08G 61/025;
C08L 65/04; G03F 1/62

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 26.04.2024  FI 20245526

(71) Applicant: **Canatu Finland Oy**
**01720 Vantaa (FI)**

(72) Inventor: **MIKLADAL, Bjørn**
**01720 Vantaa (FI)**

(74) Representative: **Papula Oy**
**P.O. Box 981**
**00101 Helsinki (FI)**

(54) **A COATED FREE-STANDING FILM OF CARBON NANOSTRUCTURES**

(57)    A structure comprising a coated free-standing film attached to a support is disclosed. The free-standing film is a free-standing film of carbon nanostructures and a parylene-coating having a thickness of 5 - 200 nm is provided on the free-standing film.

Fig. 1

EP 4 657 157 A1

**Description**

**TECHNICAL FIELD**

The present disclosure relates to a structure comprising a coated free-standing film attached to a support. The present disclosure relates to a method and a use for reducing gas permeability through a structure comprising a free-standing film of carbon nanostructures attached to a support and a metal-based coating, while allowing transmittance of ionizing radiation. Further, is disclosed the use of the structure.

**BACKGROUND**

Extreme ultraviolet lithography (EUV or EUVL) is an optical lithography technology using a range of extreme ultraviolet wavelengths. EUV pellicle films are used to protect a photomask from defects, enhance precision, shorten processing, and increase production efficiency on a wafer. However, defects in printing remain a key constraint to EUV lithography uptake. Thus, sophisticated particle filters like the EUV pellicle film are needed.

**SUMMARY**

A structure comprising a coated free-standing film attached to a support is disclosed. The free-standing film is a free-standing film of carbon nanostructures. A parylene-coating having a thickness of 5 - 200 nm is provided on the free-standing film.

Further is disclosed a method for reducing gas permeability through a structure comprising a free-standing film of carbon nanostructures attached to a support and a metal-based coating, while allowing transmittance of ionizing radiation, wherein the method comprises providing the structure with a parylene-coating having a thickness of 5 - 200 nm.

Further is disclosed the use of a parylene-coating for reducing gas permeability through a structure comprising a free-standing film of carbon nanostructures attached to a support and a metal-based coating, while allowing transmittance of ionizing radiation, by providing the structure with a parylene-coating having a thickness of 5 - 200 nm.

Further is disclosed the use of the structure as disclosed in the current disclosure as a sensor, an optical filter, a debris filter, a pellicle, a membrane filter, an electron blocking window, or any combination of at least two of these.

**BRIEF DESCRIPTION OF THE DRAWINGS**

The accompanying drawing, which is included to provide a further understanding of the embodiments and constitute a part of this specification, illustrates an embodiment and together with the description helps to explain the principles of the invention. In the drawing:

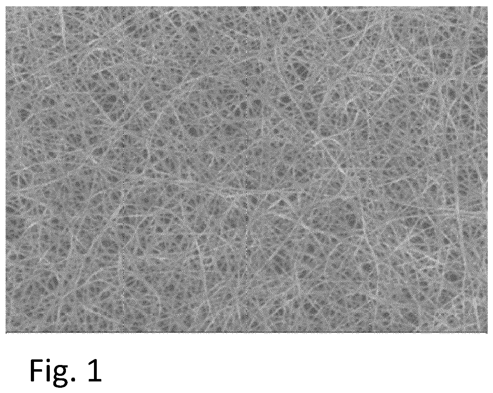

FIG. 1 illustrates a scanning electron microscope (SEM) micrograph of a structure according to one embodiment.

**DETAILED DESCRIPTION**

The present disclosure relates to a structure comprising a coated free-standing film attached to a support, wherein the free-standing film is a free-standing film of carbon nanostructures and wherein a parylene-coating having a thickness of 5 - 200 nm is provided on the free-standing film.

The present disclosure further relates to a method for reducing gas permeability through a structure comprising a free-standing film of carbon nanostructures attached to a support and a metal-based coating, while allowing transmittance of ionizing radiation, wherein the method comprises providing the structure with a parylene-coating having a thickness of 5 - 200 nm.

The present disclosure further relates to the use of a parylene-coating for reducing gas permeability through a structure comprising a free-standing film of carbon nanostructures attached to a support and a metal-based coating, while allowing transmittance of ionizing radiation, by providing the structure with a parylene-coating having a thickness of 5 - 200 nm.

The ability of the structure to transmit and/or block electromagnetic radiation may be determined by a high spectral resolution transmission measurement using a synchrotron. The measurement may be carried out to establish the suitability of the structure to be use in further applications such as for EUV applications.

The structure thus is configured to transmit ionizing radiation. I.e. the structure is able to transmit "high energy radiation" such as X-radiation and extreme ultraviolet radiation. In one embodiment, the structure is configured to transmit X-radiation and extreme ultraviolet radiation. In one embodiment, the structure is configured to transmit X-radiation or extreme ultraviolet radiation.

The structure may be a sensor, a filter, a pellicle, an electron blocking window, or any combination of at least two of these.

The structure may be a sensor, an optical filter, a debris filter, a pellicle, a membrane filter, an electron blocking window, or any combination of at least two of these.

The present disclosure further relates to the use of the structure as disclosed in the current disclosure as a sensor, an optical filter, a debris filter, a pellicle, a membrane filter, an electron blocking window, or any combination thereof.

An optical filter is a filter or device that that selectively transmits light or radiation of different wavelengths. An x-ray optical filter thus transmits x-ray radiation but may reject radiation of some different wavelength(s). Similarly, the EUV (extreme ultraviolet) optical filter may transmit EUV radiation but may reject radiation of some different wavelength(s). Another filter example is a debris filter, or a particle filter as it may also be called. An example of a debris filer is the EUV debris filter, that may transmit EUV radiation but may block debris and particles from passing through.

An electron blocking window is a device that block electrons from transmitting through. An example of an electron blocking window is the electron blocking X-radiation window. An electron blocking X-radiation window is a device that transmits x-ray radiation and blocks electrons from transmitting through.

In one embodiment, the optical filter is an X-ray optical filter, an extreme ultraviolet (EUV) optical filter, or a combination of these. In one embodiment, the optical filter is an X-ray optical filter and an extreme ultraviolet (EUV) optical filter. In one embodiment, the optical filter is an X-ray optical filter or an extreme ultraviolet (EUV) optical filter.

In one embodiment, the filter is used as an EUV debris filter, an EUV optical filter, or as a combination of these. In one embodiment, the filter is used as an EUV debris filter and an EUV optical filter. In one embodiment, the filter is used as an EUV debris filter or an EUV optical filter.

In one embodiment, the sensor is a wearable and implantable sensor, a biosensor, a gas sensor, an electrochemical sensor, a touch sensor, or a strain sensor.

In one embodiment, the pellicle is an extreme ultraviolet lithography pellicle or a high transmission pellicle.

A structure comprising a coated free-standing film attached to a support is disclosed. A parylene-coating may be provided on the free-standing film. The expression that a coating is "on" the free-standing film of carbon nanostructures should be understood in this specification, unless otherwise stated, as meaning that the coating is provided or formed to lie on or upon the free-standing film of carbon nanostructures. The free-standing film of carbon nanostructures may serve as a carrier or support structure for the coating. In one embodiment, the parylene-coating is provided directly on the free-standing film of carbon nanostructures without further layers, coatings, or films being situated there between. However, in other embodiments, e.g. a metal-based coating may be provided between the parylene-coating and the free-standing film of carbon nanostructures.

In one embodiment, the parylene is un-substituted parylene (parylene N), chlorinated parylene (parylene C, parylene D), fluorinated parylene (parylene AF-4), alkyl-substituted parylene (parylene M, parylene E), reactive parylene (parylene A, Parylene AM), colored parylene, or cross-linked parylene (parylene X), or any combination of at least two of these. The colored parylene may be considered as parylene having a chromophore directly attached to the [2.2] paracyclophane base molecule to impart color to parylene.

In one embodiment, the parylene is un-substituted parylene, i.e. parylene N. Parylene N has the added utility of containing only carbon and hydrogen, which makes its structure close to the one of carbon nanotubes or carbon nanobuds.

The inventors observed that it is possible to provide a thin parylene-coating on a free-standing film of carbon nanostructures. I.e. to directly deposit a parylene-coating on a film that is not supported throughout its whole area. Providing a parylene-coating on the free-standing film of carbon nanostructures has the added utility of the parylene providing a so-called planarization layer on the carbon nanostructure film that then allows the formation of a smooth metal-based coating thereon. Thus, parylene may be deposited from a gas phase on a porous surface, making the porous surface smooth and even for further coatings.

The parylene-coating has the added utility of providing a gas seal to the structure by blocking holes that may be formed between the carbon nanostructures in the free-standing film. Using parylene-coating to fill any holes in the free-standing film of carbon nanostructures has the added utility that the parylene-coating does not harm the transmittance of the formed structure. As the parylene-coating may be made from a gas phase it may thus form a conformal coating on the free-standing film of carbon nanostructures making the surface smoother and providing a more defect-free surface.

Providing a parylene-coating between the free-standing film of carbon nanostructures and the metal-based coating may also significantly slow down the oxidation effect of the metal-based coating. Chemical deposition of an inorganic layer on a film of carbon nanostructures is generally considered burdensome due to oxidization of the film of carbon nanostructures.

Without bounding to any specific theory why the oxidation is slowed down, one may consider that this is due to the lower surface area of the inorganic layer, e.g the metal-based coating.

The metal-based coating may be of used in devices having an optical function, to cut certain wavelength away. Thus, the structure can be used e.g. as an optical filter that has relatively low X-ray/EUV absorption but high e.g. IR absorption.

In one embodiment, the parylene-coating is provided only on one side of the free-standing film of carbon nanostructures. In one embodiment, the parylene-coating is provided on both sides of the free-standing film of carbon nanostructures. Providing a parylene-coating on both sides of the free-standing film has the added utility of providing enhanced mechanical performance as the carbon nanostructures may then be fully embedded by the parylene coating.

In one embodiment, the structure comprises a parylene-coating provided only on one side of the free-standing film of carbon nanostructures. In one embodiment, the structure comprises a parylene-coating provided on both sides of the free-standing film of carbon nanostructures.

In one embodiment, the parylene-coating has a thickness of 10 - 190 nm, or 15 - 170 nm, or 20 - 150 nm, or 25 - 130 nm, or 30 - 100 nm, or 35 - 80 nm, or 40 - 60 nm. The thin parylene-coating has the added utility of reducing the amount of light absorption. The thickness of the parylene-coating may be measured by using thin-film intereference and absorbance at 233 nm. When the refractive index of the parylene-coating is known, then the thin-film interference pattern can be used to calculate the thickness of the coating. Fresnel equations, Snell's law, and trigonometry can be used to calculate the thickness of a coating with a known refractive index. The following equation may be used:

$$m*\alpha = 2 * n * d * cos(angle)$$

$$(m-0.5)* \alpha = 2 * n * d * cos(angle)$$

m = a positive integer
$\alpha$ = wavelength (nm)
n = refractive index
d = thickness of coating
angle = refraction angle in the coating

The free-standing film of carbon nanostructures is thus attached to a support. The support may be any type of support suitable to be attached with the free-standing film of carbon nanostructures. In one embodiment, the support is formed of glass, metal, plastic, or any combination thereof. The form of the support may vary. The support may have the form of a frame. In one embodiment, the support has the form of a frame, and the film or carbon nanostructures is attached to the frame. The frame may support the free-standing film of carbon nanostructures at the outer edges thereof such that an unsupported standalone region of the carbon nanostructure film is formed. The support positions may be located anywhere in the structure as long as they provide sufficient support for the carbon nanostructure film. For example, they may be on the sides of the free-standing film of carbon nanostructures, or in areas near corners, or next to each other along the sides. Any wider area that includes a plurality of support points is also meant to be covered by this aspect, for example if the frame has an uninterrupted circular shape wherein the free-standing region lies within the circle. The frame may also have any other prolonged uninterrupted shape. In one embodiment, the frame is shaped as a circle, a square, a triangle, a rectangle, an oval, or a polygon.

Carbon nanostructures are used to form the free-standing film. The expression "nanostructures" should be understood in this specification, unless otherwise stated, as structures with one or more characteristic dimensions in nanometer scale, i.e. at most about 100 nanometers. The dimensions of the conductive nanostructures, in two perpendicular directions, may be in significantly different magnitudes of order. For example, a nanostructure may have a length which is ten, hundred, or even hundred thousand, times higher than its thickness or width. In a film of carbon nanostructures, a great number of said carbon nanostructures are interconnected with each other to form a network of interconnected molecules. As considered at a macroscopic scale, such a network forms a solid, monolithic material in which the individual molecular structures are disoriented or non-oriented, i.e. are oriented substantially randomly, or oriented. Various types of carbon nanostructure networks can be produced in the form of thin transparent layers.

In one embodiment, the carbon nanostructures comprise carbon nanotubes (CNT), carbon nanobuds (CNB), carbon nanoribbons, or any combination or mixture thereof. In one embodiment, the carbon nanostructures comprise carbon nanotubes, carbon nanobuds, or a combination or mixture of these. The carbon nanobuds, or the carbon nanobud molecules as they also may be called, have fullerene or fullerene-like molecules covalently bonded to the side of a tubular carbon molecule. Carbon nanotubes and carbon nanobuds as such have the added utility of being highly transparent in the X-ray and visible light wavelengths. In addition, they have robust mechanical properties and high chemical inertness.

Various procedures exist in the art that may be used for forming the free-standing film of carbon nanostructures. Different manners may be used to synthesize the carbon nanostructures and/or to deposit the same to form a film. In the case of e.g. carbon nanotubes or carbon nanobud molecules, deposition may be carried out, for example, by using the commonly known methods of filtration from gas phase or from liquid, deposition in a force field, or deposition from a solution using spray coating or spin drying. The carbon nanobud molecules can be synthesized, for example, using the method disclosed in WO 2007/057501, and deposited on a substrate, for example, directly from the aerosol flow, e.g. by assistance of e.g. electrophoresis or thermo-phoresis, or by a method described in Nasibulin et al: "Multifunctional Free-Standing Single-Walled 20 Carbon Nanotube Films", ACS NANO, vol. 5, no. 4, 3214-3221, 2011. Functionalization of carbon nanostructures may be considered as the generation of functional groups on the surfaces of the carbon nanostructures. Functionalization of the carbon nanostructures has the added utility of making them more reactive, increasing their solubility, or allowing various chemical modifications, such as ion adsorption, metal deposition, or grafting reactions.

A free-standing film of carbon nanostructures may be formed by synthesizing carbon nanostructures e.g. in a gas phase from where they are collected or deposited. The film of carbon nanostructures may be formed by collecting or depositing the synthesized carbon nanostructures firstly in one direction in reaction chamber, the rotating the same e.g. 90 degrees and to continue collecting or depositing further carbon nanostructures thereon. Alternatively, the carbon nanostructures may be randomly collected or deposited to form a film of carbon nanostructures.

In one embodiment, the coated free-standing film has the size of 0.1 - 1000 cm$^2$, or 1 - 500 cm$^2$, or 5 - 350 cm$^2$, or 10 - 200 cm$^2$, or 50 - 150 cm$^2$.

In one embodiment, the thickness of the free-standing film of carbon nanostructures is 9 - 8000 nm, or 15 - 7000 nm, or 20 - 5000 nm, or 50 - 2500 nm, or 100 - 1000 nm, or 200 - 600 nm. In one embodiment, the thickness of the free-standing film of carbon nanostructures is 9 - 600 nm, or 15 - 500 nm, or 20 - 400 nm, or 50 - 300 nm, or 100 - 200 nm. In one embodiment, the thickness of the free-standing film of carbon nanostructures is 100 - 8000 nm, or 200 - 7000 nm, or 300 - 5000 nm, or 400 - 2500 nm, or 500 - 1000 nm. The thickness of the free-standing film of carbon nanostructures may be measured with a contact profilometer, such as atomic force microscopy (AFM), an optical profilometer, or an ellipsometry, cross-sectional electron microscopy. Forming a free-standing film of carbon nanostructures has the added utility of one being able to form a thin film. However, the free-standing film of carbon nanostructures may not be too thin as this would affect its ability to support itself when attached to the support.

In one embodiment, a metal-based coating is provided on the parylene-coating. In one embodiment, the parylene-coating is provided between the metal-based coating and the free-standing film of carbon nanostructures. In one embodiment, a metal-based coating is provided between the parylene-coating and the free-standing film of carbon nanostructures. In one embodiment, a first metal-based coating is provided on the parylene-coating and a second metal-based coating is provided between the parylene-coating and the free-standing film of carbon nanostructures. The metal-based coating may at least partly or completely be embedded inside the parylene-coating.

The structure may comprise a metal-based coating. The structure may comprise a metal-based coating on the free-standing film of carbon nanostructures, which are surrounded by the parylene-coating. Surrounding with a parylene-coating has the added utility of the parylene filling any pinholes in the metal-based coating and/or in the free-standing film of carbon nanostructures, while simultaneously reducing oxidation of the metal-based coating and enhancing the mechanical properties of the structure.

In one embodiment, the metal-based coating has a thickness of 1 - 300 nm, or 1 - 100 nm, or 1 - 50 nm, or 1 - 30 nm, or 1 - 20 nm, or 1 - 10 nm. The thickness of the metal-based coating may be measured with e.g. transmission electron microscopy (TEM) technique, scanning electron microscopy (SEM) technique, or any other relevant technique.

The metal-based coating may be formed of aluminium, zirconium, molybdenum, metal silicide, ruthenium, beryllium, niobium, or any a carbide, an oxide, or a nitrate thereof, or any combination or mixture thereof. The metal-based coating may comprise or consist of aluminium, zirconium, molybdenum, metal silicide, ruthenium, beryllium, niobium, or any a carbide, an oxide, or a nitrate thereof, or any combination or mixture thereof. In one embodiment, the metal-based coating is a metal-based blocking layer, which is configured to block electromagnetic radiation with a wavelength above 400 nm, or above 450 nm, or above 500 nm. The metal-based coating has the added utility of blocking radiation of undesired wavelength to pass through the filter. The metal-based coating has the further added utility of functioning as a gas barrier.

In one embodiment, the structure comprises a polymer layer. In one embodiment, a polymer layer is provided on the parylene-coating. In one embodiment, the parylene-coating is provided between the polymer layer and the free-standing film of carbon nanostructures. The polymer layer has the added utility of blocking lower energy radiation, such as near UV radiation and visible light, from penetrating the structure. A polymer coating that may absorb visible light may thus provide a dark color. As an example may be mentioned conductive forms of polyaniline that may exhibit a dark color due to its ability to absorb light across the visible spectrum.

In one embodiment, the parylene-coating is provided on the free-standing film carbon nanostructures. In one embodiment, the parylene-coating is deposited from a gas phase. The parylene-coating may be formed or deposited by pyrolysis at a temperature of 600 - 750 °C, or 650 - 700 °C, or 680 - 690 °C, of a selected dimer in a vacuum environment. The dimer is thus vaporized into a dimeric gas. Thereafter the deposition is carried on a cooler (i.e. room temperature) surface inside a deposition chamber while under continuous vacuum.

The structure as disclosed in the current disclosure has the added utility of being a structure able to reduce or hinder gas from passing the structure while allowing certain radiation to pass the same. The gas may be e.g. an inert gas, which one may desire to block from passing through the structure in certain applications.

The structure as disclosed in the current disclosure has the added utility of comprising a thin parylene-coating and thus reducing light from absorbing into the structure. The thin parylene-coating has the added utility of reducing or hindering oxidation of the possibly used metal-based coating, which would lead to light being absorbed by the structure.

**EXAMPLES**

Reference will now be made in detail to the described embodiments, an example of which is illustrated in the accompanying drawing.

The description below discloses some embodiments in such a detail that a person skilled in the art is able to utilize the method based on the disclosure. Not all steps of the embodiments are discussed in detail, as some of the steps may be obvious for the person skilled in the art based on this specification.

Fig. 1 illustrates a SEM micrograph of a structure comprising a parylene-N coating with a thickness of 10 nm on a free-standing film of carbon nanotubes.

Example 1 - Producing a structure comprising a parylene-coating

In this example different structures were produced and tested for their ability to transmit EUV radiation and to block certain gases to pass the structure. The materials used are presented in Table 1.

Table 1. Materials used for producing the structures

|  | Material |
|---|---|
| Porous collection filter | Mixed cellulose ester |
| Support | circular frame of steel* |
| Carbon nanostructures | Carbon nanotubes |
| Parylene coating | Parylene N |
| Metal-based coating | $MoSi_2$ |
| *A circular frame, 21 mm inner diameter, 37 mm outer diameter | |

Example structures and a comparative structure were prepared as presented in Table 2.

Table 2. Properties of the structures

|  | Example structure 1 | Example structure 2 | Comparative example |
|---|---|---|---|
| Free-standing film of carbon nanotubes | 80 nm | 80 nm | 80 nm |
| Parylene coating of parylene N | 185 nm | 185 nm | - |
| Metal-based coating of $MoSi_2$ | 18 nm | - | 18 nm |

Firstly, carbon nanotubes were synthesized in an aerosol laminar flow (floating catalyst) reactor using carbon monoxide and ferrocene as a carbon source and a catalyst precursor, respectively. The formed carbon nanotubes were deposited from the gas phase onto a porous collection filter at a total gas flow rate of 60 l/min (gas velocity of max 0.13 m/s) to form a film of carbon nanotubes on the porous collection filter. The temperature of the gas was about 60 °C. The thickness of the formed film of carbon nanotubes was 50 nm, which corresponds to 81%T at 550 nm wavelength.

The formed film of carbon nanotubes was then transferred from the porous collection filter to a rectangular plastic frame that was larger than the final circular frame. Then the same was transferred to the final circular-shaped frame to form a free-standing film of carbon nanotubes attached to the frame. The frame thus had a circular form with an opening in the middle.

Thereafter either a parylene-coating was formed on the free-standing film of carbon nanotubes followed by forming a metal-based coating on the parylene-coating (example structures) or alternatively the metal-based coating was formed directly on the free-standing film of carbon nanotubes, whereas the structure comprised no parylene-coating (comparative example).

The parylene-coating was formed by pyrolysis at about 680 °C of a di-p-xylene (dimer) in a vacuum environment which was then deposited on a cooler (i.e. room temperature) substrate inside the deposition chamber while under continuous vacuum. The thickness of the parylene coating was 185 nm.

The metal-based coating was a metal-based coating of $MoSi_2$ having a thickness of 18 nm. Magnetron sputtering using DC power was used to form the metal-based coating.

The formed structures were subjected EUV and DUV (deep ultraviolet radiation) measurements by using a particle accelerator (MAX IV synctrotron). The results are presented in Table3.

Table 3. Results of measurements for the example structures and the comparative example

|  | EUV | DUV |
|---|---|---|
| Example structure 1 | 46 % | 0.1 % |
| Example structure 2 | 48 % | 1.0 % |
| Comparative example | 68 % | 10.0 % |

From the results one can see that for the comparative example that did not include the parylene-N coating, the EUV transmittance of the $MoSi_2$ layer was much lower than anticipated. This can be considered due to $MoSi_2$ oxidized into $MoO_3$ and $SiO_2$. Such phenomenon did not take place when a parylene-N coating was formed between the free-standing film of carbon nanotubes and the metal-based coating thus hindering such oxidation to take place. The use of the parylene-coating has thus the added utility of hindering the oxidation of the $MoSi_2$-coating into the more EUV absorbing compounds of $MoO_3$ and $SiO_2$.

Further, it was note that the parylene-coating efficiently blocked holes present in the free-standing film of carbon nanotubes thus reducing its gas permeability to a great extent.

It is obvious to a person skilled in the art that with the advancement of technology, the basic idea may be implemented in various ways. The embodiments are thus not limited to the examples described above; instead they may vary within the scope of the claims.

The embodiments described hereinbefore may be used in any combination with each other. Several of the embodiments may be combined together to form a further embodiment. A structure, a method, or a use, as disclosed herein, may comprise at least one of the embodiments described hereinbefore. It will be understood that the benefits and advantages described above may relate to one embodiment or may relate to several embodiments. The embodiments are not limited to those that solve any or all of the stated problems or those that have any or all of the stated benefits and advantages. It will further be understood that reference to 'an' item refers to one or more of those items. The term "comprising" is used in this specification to mean including the feature(s) or act(s) followed thereafter, without excluding the presence of one or more additional features or acts.

**Claims**

1. A structure comprising a coated free-standing film attached to a support, wherein the free-standing film is a free-standing film of carbon nanostructures and wherein a parylene-coating having a thickness of 5 - 200 nm is provided on the free-standing film.

2. The structure of claim 1, wherein the parylene is un-substituted parylene, chlorinated parylene, fluorinated parylene, alkyl-substituted, parylene, reactive parylene, colored parylene, or cross-linked parylene, or any combination of at least two of these.

3. The structure of any one of the preceding claims, wherein the parylene-coating is provided only on one side of the free-standing film of carbon nanostructures.

4. The structure of any one of the preceding claims, wherein the parylene-coating is provided on both sides of the free-standing film of carbon nanostructures.

5. The structure of any one of the preceding claims, wherein parylene-coating has a thickness of 10 - 190 nm, or 15 - 170 nm, or 20 - 150 nm, or 25 - 130 nm, or 30 - 100 nm, or 35 - 80 nm, or 40 - 60 nm.

6. The structure of any one of the preceding claims, wherein the free-standing film of carbon nanostructures has a thickness of 8 - 8000 nm, or 15 - 7000 nm, or 20 - 5000 nm, or 50 - 2500 nm, or 100 - 1000 nm, or 200 - 600 nm.

7. The structure of any one of the preceding claims, wherein the support is formed of glass, metal, plastic, or any combination thereof.

8. The structure of any one of the preceding claims, wherein the coated free-standing film has the size of 0.1 - 1000 $cm^2$,

or 1 - 500 cm$^2$, or 5 - 350 cm$^2$, or 10 - 200 cm$^2$, or 50 - 150 cm$^2$.

9. The structure of any one of the preceding claims, wherein a metal-based coating is provided on the parylene-coating.

10. The structure of any one of the preceding claims, wherein a metal-based coating is provided between the parylene-coating and the free-standing film of carbon nanostructures.

11. The structure of claim 9 or claim 10, wherein the metal-based coating has a thickness of 1 - 300 nm, or 1 - 100 nm, or 1 - 50 nm, or 1 - 30 nm, or 1 - 20 nm, or 1 - 10 nm.

12. The structure of any one of the preceding claims, wherein the structure is a sensor, an optical filter, a debris filter, a pellicle, a membrane filter, an electron blocking window, or any combination of at least two of these.

13. A method for reducing gas permeability through a structure comprising a free-standing film of carbon nanostructures attached to a support and a metal-based coating, while allowing transmittance of ionizing radiation, wherein the method comprises providing the structure with a parylene-coating having a thickness of 5 - 200 nm.

14. Use of a parylene-coating for reducing gas permeability through a structure comprising a free-standing film of carbon nanostructures attached to a support and a metal-based coating, while allowing transmittance of ionizing radiation, by providing the structure with a parylene-coating having a thickness of 5 - 200 nm.

15. The use of claim 14, wherein the parylene-coating is provided such that the metal-based coating is situated between the parylene-coating and the free-standing film of carbon nanostructures.

16. The use of any one of claims 14 - 15, wherein the parylene-coating is provided between the metal-based coating and the free-standing film of carbon nanostructures.

17. The use of any one of claims 14 - 16, wherein the parylene-coating is deposited from a gas phase.

18. Use of the structure of any one of claims 1 - 12 as a sensor, an optical filter, a debris filter, a pellicle, a membrane filter, an electron blocking window, or any combination thereof.

19. The use of claim 18, wherein the pellicle is an extreme ultraviolet lithography pellicle.

Fig. 1

**EUROPEAN SEARCH REPORT**

Europäisches
Patentamt
European
Patent Office
Office européen
des brevets

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MARTY L ET AL: "Integration of self-assembled carbon nanotube transistors: statistics and gate engineering at the wafer scale; Integration of self-assembled carbon nanotube transistors: statistics and gate engineering at the wafer scale", NANOTECHNOLOGY, IOP PUBLISHING, ENGLAND, vol. 17, no. 20, 28 October 2006 (2006-10-28), pages 5038-5045, XP020104212, ISSN: 0957-4484, DOI: 10.1088/0957-4484/17/20/002 | 1-8 | INV. G03F1/62 G03F7/20 C08G61/02 C01B32/15 C08L65/04 |
| A | * the whole document * | 9-19 | |
| X | AKIRA INABA ET AL: "Paper;Electrochemical impedance measurement of a carbon nanotube probe electrode;Electrochemical impedance measurement of a carbon nanotube probe electrode", NANOTECHNOLOGY, IOP PUBLISHING, ENGLAND, vol. 23, no. 48, 2 November 2012 (2012-11-02), page 485302, XP020233872, ISSN: 0957-4484, DOI: 10.1088/0957-4484/23/48/485302 | 1-6,8, 12,18 | TECHNICAL FIELDS SEARCHED (IPC) G03F C08G C01B C08L |
| A | * the whole document * | 9-11, 13-17,19 | |
| A | US 2019/056654 A1 (PÉTER MÁRIA [NL] ET AL) 21 February 2019 (2019-02-21) * paragraphs [0113] - [0151] * | 1-19 | |
| A | US 2019/120787 A1 (SZKOPEK THOMAS [CA] ET AL) 25 April 2019 (2019-04-25) * paragraphs [0037], [0038]; claims 1,2 * | 1-19 | |

The present search report has been drawn up for all claims

| Place of search | Date of completion of the search | Examiner |
|---|---|---|
| Munich | 6 October 2025 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

**EP 4 657 157 A1**

## ANNEX TO THE EUROPEAN SEARCH REPORT
## ON EUROPEAN PATENT APPLICATION NO.

EP 25 17 1522

This annex lists the patent family members relating to the patent documents cited in the above-mentioned European search report.
The members are as contained in the European Patent Office EDP file on
The European Patent Office is in no way liable for these particulars which are merely given for the purpose of information.

06-10-2025

| Patent document cited in search report | Publication date | Patent family member(s) | Publication date |
|---|---|---|---|
| US 2019056654 A1 | 21-02-2019 | CA 3002702 A1 | 27-04-2017 |
| | | CN 108431693 A | 21-08-2018 |
| | | EP 3365730 A2 | 29-08-2018 |
| | | JP 6784757 B2 | 11-11-2020 |
| | | JP 2018531426 A | 25-10-2018 |
| | | KR 20180072786 A | 29-06-2018 |
| | | NL 2017606 A | 10-05-2017 |
| | | TW 201725178 A | 16-07-2017 |
| | | US 2019056654 A1 | 21-02-2019 |
| | | WO 2017067813 A2 | 27-04-2017 |
| US 2019120787 A1 | 25-04-2019 | NONE | |

EPO FORM P0459

For more details about this annex : see Official Journal of the European Patent Office, No. 12/82

**11**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2007057501 A

**Non-patent literature cited in the description**

- **NASIBULIN et al.** Multifunctional Free-Standing Single-Walled 20 Carbon Nanotube Films. *ACS NANO*, 2011, vol. 5 (4), 3214-3221